# DEMANDE DE BREVET EUROPEEN

(11) **EP 4 287 265 A1**
(43) Date de publication de la demande: **06.12.2023**
(21) Numéro de dépôt: 23175619.8
(22) Date de dépôt: 26.05.2023
(51) Int. Cl.: H01L 29/778, H01L 21/338, H01L 29/06, H01L 29/10, H01L 29/417, H01L 29/20

(54) **COMPOSANT ÉLECTRONIQUE À BASE DE NITRURE DE GALIUM DOPE P**

(30) Priorité: 30.05.2022 FR 2205158
(71) Demandeur: Commissariat à l'énergie atomique et aux énergies alternatives, 75015 Paris (FR)
(72) Inventeur: MORVAN, Erwan, 38054 GRENOBLE CEDEX 09 (FR)
(74) Mandataire: Cabinet Camus Lebkiri

(57) **Abrégé**

L'invention a pour objet un composant électronique (100) comprenant :
- Un substrat (107)
- Un empilement actif (101i) formé au-dessus du substrat et incluant :
• une couche (110i) en Nitrure de Galium GaN dopé de type p, disposée au-dessus du substrat (107) ;
• une couche (111i) en un matériau semi-conducteur disposée sur la couche (110i) en Nitrure de Galium GaN dopé de type p ;

le composant comportant deux zones latérales (105i) situées de part et d'autre de la couche (110i) de GaN dopé de type p, les deux zones latérales étant implantées en oxygène.

## Description

### DOMAINE TECHNIQUE DE L'INVENTION

La présente invention est relative aux composants électroniques à base de nitrure de galium (GaN) dopé p et plus particulièrement aux composants électroniques de puissance à hétérojonction à base de GaN, tels que les transistors à haute mobilité d'électrons (ou HEMT, pour « High Electron Mobility Transistor » en anglais) et les diodes Schottky.

### ARRIERE-PLAN TECHNOLOGIQUE DE L'INVENTION

Le nitrure de gallium est aujourd'hui un matériau très prisé pour la réalisation de différents composants électroniques. C'est le cas notamment des diodes émettrices de lumière, des diodes Schottky et des transistors dits à haute mobilité d'électrons HEMT. Ces composants nécessitent l'utilisation de semiconducteurs dopés de type p et n. L'épitaxie à sources organométalliques est la technique de croissance la plus répandue pour l'obtention de ces composants. Or l'hydrogène est un des contaminants les plus importants des semi-conducteurs élaborés à partir des précurseurs organométalliques. L'un des inconvénients liés à la présence de l'hydrogène est que ce dernier va neutraliser les accepteurs lorsque l'on cherche à obtenir un semiconducteur dopé p. Cette neutralisation se fait par la formation de complexes accepteur-hydrogène électriquement inactifs, rendant plus difficile l'obtention d'un dopage p efficace.

Le problème évoqué ci-dessus concernant l'obtention d'un dopage p efficace entravé par la présence d'hydrogène se retrouve notamment lors de la réalisation de composants à base de GaN tels que les transistors à hétérojonction de type HEMT tant pour des applications RF (amplification, amplification faible bruit LNA Low Noise Amplifier, commutateurs ou switch, oscillateurs...) que pour des applications de puissance (transistor de puissance pour la conversion d'énergie). Un gaz bidimensionnel d'électrons (ou 2DEG, pour « 2-Dimensional Electron Gaz » en anglais) est formé sous l'interface entre une couche barrière (par exemple en AlGaN, InAlN, InAlN, AlN, ScAlN, AlN, InAlGaN...) et le canal (par exemple en GaN). Ce 2DEG est connecté au niveau de la source et du drain par des contacts ohmiques métalliques et est contrôlé par une grille (de type Schottky ou MIS Métal-Isolant-Semiconducteur).

Une hétérojonction est formée par la jonction de deux matériaux semi-conducteurs ayant des bandes interdites différentes. Par exemple, une hétérojonction du type AlGaN/GaN comprend une couche de nitrure de galium (GaN) surmontée d'une couche de nitrure d'aluminium-gallium (AlGaN). Le 2DEG se forme sous l'interface entre la couche d'AlGaN et la couche de GaN, du fait d'une polarisation spontanée et d'une polarisation piézoélectrique. Ce gaz d'électrons bidimensionnel sert de canal de conduction au sein des composants électroniques à hétérojonction, tels que les transistors HEMT et les diodes Schottky.

Un composant électronique à hétérojonction AlGaN/GaN est généralement fabriqué à partir d'un substrat semi-conducteur (par exemple en silicium, saphir ou SiC), en faisant croître successivement par épitaxie une couche de nucléation, une ou plusieurs couches de transition, une couche tampon épaisse et les couches de l'hétérojonction (canal GaN, puis barrière AlGaN). La couche tampon, de plusieurs microns d'épaisseur, permet de limiter les courants de fuite latéraux et verticaux dans le composant et de mieux confiner le gaz d'électrons bidimensionnel de l'hétérojonction. La couche tampon, semi-isolante, est par exemple formée de GaN dopé au carbone.

Ce type de composant supporte des densités de courant élevées à l'état passant, en raison de la forte densité de porteurs de charge (électrons) et de la grande mobilité de ces porteurs dans le gaz d'électrons bidimensionnel. Il souffre cependant d'un phénomène transitoire d'effondrement du courant à l'état passant (communément appelé « current collapse » en anglais). Ce phénomène est lié à un piégeage de charges dans la structure épitaxiée, et plus particulièrement dans la couche tampon en GaN dopé au carbone. Des pièges se chargent négativement lorsque le composant est dans l'état bloqué puis appauvrissent le gaz d'électrons bidimensionnel de retour à l'état passant, par effet de couplage capacitif. L'appauvrissement du gaz d'électrons bidimensionnel entraîne une augmentation de la résistance dynamique et du courant de saturation de drain à l'état passant du composant (et donc une diminution du courant à l'état passant).

La demande de brevet FR3047607 décrit un exemple de structure de transistor à hétérojonction, qui adresse ce problème d'effondrement du courant à l'état passant.

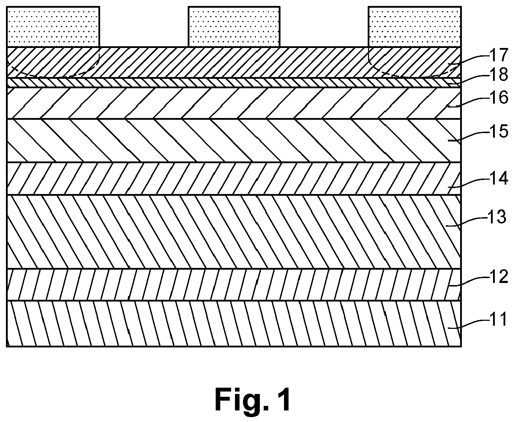

En référence à la figure 1, cette première structure de transistor comprend un substrat 11, au moins une couche de transition 12 disposée sur le substrat 11, une couche tampon 13 (par exemple en GaN dopé carbone) disposée sur la couche de transition 12, une couche de GaN dopé p 14 disposée sur la couche tampon 13, une couche de GaN dopé n 15 disposée sur la couche de GaN dopé p 14, une couche de GaN non intentionnellement dopé 16 disposée sur la couche de GaN dopé n 15 et une couche d'AlGaN 17 disposée sur la couche de GaN non intentionnellement dopé 16. La couche de GaN non intentionnellement dopé 16 et la couche d'AlGaN 17 forment l'hétérojonction. Un gaz d'électrons bidimensionnel est intrinsèquement formé sous l'interface entre la couche de GaN non intentionnellement dopé 16 et la couche d'AlGaN 17. Ce gaz d'électrons bidimensionnel est illustré sur la figure 1 sous la forme d'une couche 18 disposée entre les couches 16 et 17.

La couche de GaN dopé p 14 et la couche de GaN dopé n 15 forment ensemble une barrière de potentiel particulièrement élevée (jonction PN déplétée) sous la couche de gaz d'électrons 18. Cette barrière de potentiel, aussi appelée barrière de confinement (ou back barrier BB selon la terminologie anglaise) améliore le confinement du gaz d'électrons bidimensionnel en réduisant le nombre d'électrons piégés dans la couche tampon 13.

La structure de transistor décrite dans la demande de brevet FR3047607 permet de limiter le phénomène d'effondrement du courant mais suppose l'utilisation d'une couche de GaN dopé p 14. Ce dopage p est par exemple obtenu par un dopage à base de magnésium Mg utilisé en tant qu'accepteur. Pour être performante, la barrière de confinement doit présenter un taux d'activation maximum du Mg. Sinon, il est nécessaire d'utiliser une concentration plus élevée de Mg pour atteindre la concentration d'accepteurs visée, ce qui entraine une plus forte concentration de Mg dans le canal jusqu'au gaz 2DEG et dégrade les propriétés de transport électronique dans le canal. Or comme nous l'avons vu plus haut, la présence d'hydrogène notamment d'origine organométallique limite l'activation du Mg.

Une solution connue à ce problème d'activation des accepteurs, ici des atomes de Mg, consiste à effectuer des recuits sous oxygène pour éviter la création de complexes entre l'hydrogène et le magnésium. Cette solution n'est toutefois pas idéale dans le cas du transistor HEMT de la figure 1 car la couche 14 de GaN dopé p se trouve au-dessous d'une série de couches formées par la couche de GaN dopé n 15, la couche de GaN non intentionnellement dopé 16 et la couche d'AlGaN 17. Ainsi, le fait que la couche 14 de GaN p soit recouverte empêche l'exo-diffusion de l'hydrogène qui reste présent dans la couche 14 de GaN p. C'est la configuration du champ électrique dans les couches supérieures qui empêche l'exodiffusion de l'hydrogène.

Cette difficulté se retrouve dans d'autres composants électroniques utilisant du GaN dopé p tels que des diodes émettrices de lumière ou certains composants de puissance où l'utilisation d'une couche p enterrée permet d'obtenir une tension de seuil positive. Dans ce cas aussi il est important d'optimiser l'activation des atomes de Mg.

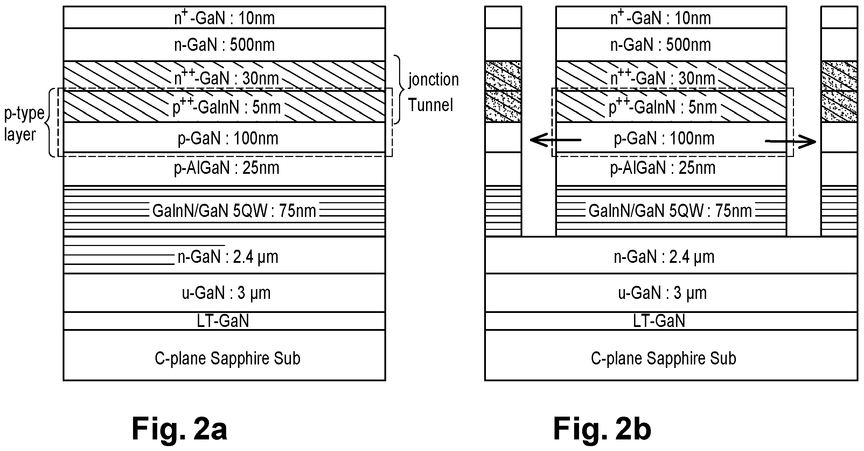

Une solution connue au problème ci-dessus a été proposé pour des applications en optoélectronique (cas des diodes émettrices de lumière) dans le document "Lateral Hydrogen Diffusion at p-GaN Layers in Nitride-Based Light Emitting Diodes with Tunnel Junctions ». Yuka Kuwano et al, Japanese Journal of Applied Physics 52 (2013) 08JK12 08JK12-1 # 2013 The Japan Society of Applied Physics. Cette solution est illustrée aux figures 2a et 2b. La figure 2a montre un empilement classique d'une diode émettrice de lumière avec une couche de GaN-p enterrée. Selon la figure 2b, l'hydrogène responsable du faible taux d'activation du Mg est évacué par les flancs du composant. L'empilement de semiconducteur III-N est gravé autour du composant et un recuit sous atmosphère contenant de l'Oxygène permet de faire diffuser et d'évacuer l'Hydrogène sur une distance de l'ordre de quelques dizaines de microns et ainsi d'améliorer l'activation du Mg.

Cette solution n'est toutefois pas satisfaisante pour l'ensemble des composants à base de GaN-p. Ainsi, pour un transistor, la réalisation de gravures peut entrainer des problèmes d'intégration (topologie) et de courants parasites. De plus, un transistor a souvent des dimensions supérieures à la longueur de diffusion de l'hydrogène et il est difficile d'envisager des gravures au sein du transistor. Cette approche n'est donc notamment pas adaptée à la fabrication de transistors. De façon plus générale, la réalisation de gravure pour l'obtention de mesa rend le procédé de fabrication d'un composant électronique plus complexe.

### RESUME DE L'INVENTION

Il existe donc un besoin de prévoir un composant électronique à base de nitrure de galium dopé p avec une activation satisfaisante des accepteurs responsables du dopage p, sans dégrader les performances du composant et facile à fabriquer, notamment lorsque ledit composant électronique est un transistor de type HEMT.

Pour ce faire, l'invention a pour objet un composant électronique comprenant :
- un substrat ;
- une couche en Nitrure de Galium GaN dopé de type p, disposée au-dessus du substrat ;
- une couche en un matériau semi-conducteur disposée sur la couche en Nitrure de Galium dopé de type p ;
le composant comportant deux zones latérales situées de part et d'autre de la couche de GaN dopé de type p, les deux zones latérales étant implantées en oxygène.

On entend par zone latérale implantée en oxygène, une zone dans laquelle une grande partie de l'oxygène est disponible pour former des liaisons covalentes avec l'hydrogène. En d'autres termes, cette zone implantée en oxygène n'est pas une zone dopée en oxygène car dans ce cas la majorité de l'oxygène présent serait en site substitutionnel dans le réseau cristallin du GaN. Ainsi, la zone implantée en oxygène doit être vue comme une zone ayant subi une étape d'implantation en atome d'oxygène et un recuit thermique mais n'ayant pas été soumise à un budget thermique suffisant pour que l'oxygène se comporte en donneur et forme une zone de GaN dopée n. L'oxygène est ici au contraire réparti aléatoirement au sein du réseau cristallin et majoritairement en position interstitielle. Après l'implantation il y a aussi une grande quantité de défauts cristallins dans la matrice (chaque atome d'oxygène implanté déplace plusieurs centaines d'atomes de la matrice).

L'invention repose sur la création de poches d'oxygène (i.e. les zones latérales) dans des zones situées de part et d'autre de la zone en GaN où l'on cherche à obtenir une activation efficace des accepteurs. Ces poches d'oxygène à proximité de la zone dopée et donc des atomes susceptibles de jouer le rôle d'accepteurs (par exemple le magnésium Mg dans le GaN) permettent à l'hydrogène, sous l'effet d'un recuit post-implantation de diffuser vers ces poches et réagir avec l'oxygène implanté de façon à réduire la formation de complexes hydrogène-accepteur. Contrairement aux solutions de l'état de la technique, le composant selon l'invention ne nécessite pas de réaliser de gravure autour de la couche de type p. Les zones latérales peuvent être aisément réalisées en partant de la couche de GaN dopé p dans laquelle on implante de l'oxygène sur ses zones latérales ; en d'autres termes, les zones latérales sont dans le même plan que la couche de GaN-p et forment les parties d'extrémité de cette couche.

Le composant selon l'invention peut également présenter une ou plusieurs des caractéristiques ci-dessous, considérées individuellement ou selon toutes les combinaisons techniquement possibles :
- Les accepteurs de la couche en Nitrure de Galium GaN dopé de type p sont des atomes de Magnésium.
- La largeur de l'empilement actif et la largeur de chacune des zones implantées en oxygène sont inférieures ou égales à 20µm et supérieures ou égales à 1µm, la largeur étant mesurée parallèlement au plan des couches dans l'alignement de l'empilement et des zones implantées en oxygène.
- L'empilement actif comporte :
   - une couche de GaN dopé de type n déposée sur la couche de GaN dopé de type p ;
   - une couche de GaN non intentionnellement dopée déposée sur la couche de GaN dopé de type n ;
   - une couche semi-conductrice déposée sur la couche de GaN non intentionnellement dopée pour former un gaz d'électrons bidimensionnel ;
   le composant comportant une zone de source, une zone de drain et une zone de grille de commande formées sur ou dans la couche semi-conductrice pour former un gaz d'électrons bidimensionnel, les deux zones latérales implantées en oxygène s'étendant également de part et d'autre de la couche de GaN dopé de type n, de la couche de GaN non intentionnellement dopée et de la couche semi-conductrice pour former un gaz d'électrons bidimensionnel.
- Le composant électronique comporte :
   - une pluralité d'empilements actifs, chaque empilement actif comportant :
   - une couche de GaN dopé de type n déposée sur la couche de GaN dopé de type p ;
   - une couche de GaN non intentionnellement dopée déposée sur la couche de GaN dopé de type n ;
   - une couche semi-conductrice déposée sur la couche de GaN non intentionnellement dopée pour former un gaz d'électrons bidimensionnel ;
   - deux zones latérales implantées en oxygène s'étendant de part et d'autre de la couche de GaN dopé de type p, de la couche de GaN dopé de type n, de la couche de GaN non intentionnellement dopée et de la couche semi-conductrice pour former un gaz d'électrons bidimensionnel
   les zones de source, de drain et de grille de commande étant communes à la pluralité d'empilement, chaque empilement étant isolé électriquement de l'empilement adjacent par une des zones latérales implantées en oxygène.

- l'ensemble desdits empilements est entouré d'une zone, dite d'isolation, ladite zone d'isolation étant une zone implantée en oxygène.
- Selon un mode de réalisation, chacune des deux zones latérales implantées en oxygène s'étend dans ou sous la zone de grille et dans ou sous la zone de drain et la zone de source ;
- Selon un autre mode de réalisation, chacune des deux zones latérales implantées en oxygène s'étend dans ou sous la zone de grille et ne s'étend pas dans ou sous la zone de drain et la zone de source.

L'invention a également pour objet un procédé de fabrication d'un composant selon l'invention comportant les étapes suivantes :
- Réalisation sur un substrat d'un empilement formé au-dessus du substrat et incluant :
   - une couche en Nitrure de Galium GaN dopé de type p, disposée au-dessus du substrat ;
   - une couche en un matériau semi-conducteur disposée sur la couche en matériau semi-conducteur ;
- Réalisation d'un masque au-dessus de l'empilement, ledit masque masquant la partie de l'empilement formant l'empilement actif ;
- Implantation ionique pour introduire des atomes d'oxygène dans les deux zones de l'empilement situé de part et d'autre de la zone masquée de sorte à obtenir deux zones latérales dans la couche en Nitrure de Galium GaN dopé de type p implantées en oxygène ;
- Recuit suivant l'implantation ionique.

Le procédé selon l'invention peut également présenter une ou plusieurs des caractéristiques ci-dessous, considérées individuellement ou selon toutes les combinaisons techniquement possibles :
- la température de recuit est comprise entre 700 et 850°C.
- l'implantation est une implantation multi-énergies.
- l'énergie des atomes d'oxygènes ionisés utilisée pour l'implantation est inférieure ou égale à 200 keV.
- la dose d'atomes d'oxygène implantés est :
   - supérieure à 2.10¹⁴cm⁻² x (Wa/Wo) où Wa désigne la largeur de l'empilement actif et Wo désigne la largeur des zones latérales implantées et ;
   - inférieure à 6.10¹⁵cm⁻²x (Wa/Wo).
- l'étape d'implantation ionique pour introduire des atomes d'oxygène s'accompagne d'une étape d'implantation ionique pour introduire des atomes d'argon ou d'azote.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
La figure 1 représente un exemple de transistor à hétérojonction selon l'art antérieur.
Les figures 2a et 2b représentent une solution d'activation du magnésium dans un composant optoélectronique selon l'art antérieur.
La figure 3 représente une vue de dessus d'un composant électronique selon un premier mode de réalisation de l'invention.
La figure 4 représente une vue en coupe du composant de la figure 3 suivant un plan perpendiculaire au plan des couches et le long du doigt de grille.
Les figures 5 à 8 représentent schématiquement les étapes du procédé de fabrication d'un composant selon l'invention.
La figure 9 représente une vue de dessus d'un composant électronique selon un second mode de réalisation de l'invention.
Les figures 10a et 10b représentent deux vues en coupe du composant de la figure 3.
Les figures 11a et 11b représentent deux vues en coupe du composant de la figure 9.
La figure 12 représente un exemple de profil d'implantation d'oxygène utilisé pour la réalisation des composants selon l'invention.

### DESCRIPTION DETAILLEE

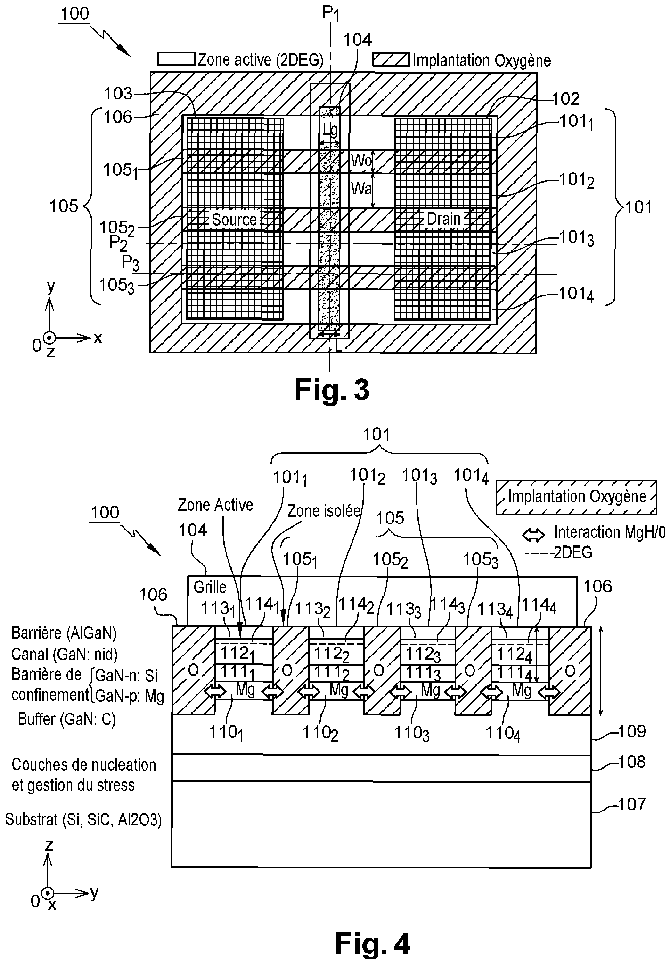

La figure 3 représente une vue de dessus d'un composant électronique 100 selon l'invention dans un plan Oxy. Selon ce mode réalisation, le composant électronique 100 est ici un transistor à haute mobilité d'électrons (ou HEMT, pour « High Electron Mobility Transistor » en anglais). Le transistor 100 comporte :
- Une zone active 101 incluant une pluralité de zones actives élémentaires 101i (i allant ici de 1 à 4) ;
- Une zone de drain 102 ;
- Une zone de source 103 ;
- Une zone de grille 104 ;
- Une zone implantée en oxygène 105 incluant :
   - une zone périphérique d'isolation 106 ;
   - une pluralité de zones élémentaires implantées en oxygène 105j (ici j allant ici de 1 à 3) agencées entre chaque zone active élémentaire 101i.

Il convient de noter que les nombres i=4 de zones actives élémentaires et j=3 de zones élémentaires implantées en oxygène sont donnés ici à titre purement illustratif et que ces nombres peuvent varier selon les applications visées.

Comme nous le verrons par la suite, l'ensemble formé par les zones élémentaires actives 101i et les zones implantées en oxygène 105j est réalisé à partir d'un même et unique empilement de couches épitaxiées dont certaines zones ont subi une implantation en oxygène et un recuit thermique, le recuit thermique étant appliqué à tout le wafer.

Les zones élémentaires actives 101i et implantées en oxygène 105j sont agencées successivement sous la forme de bandes parallèles suivant la direction Ox de sorte qu'une zone élémentaire active 101i est soit entourées de deux zones élémentaires implantées en oxygène 105j et 105j₊₁ (cas des zones élémentaires actives 101₂ et 101₃) soit d'une zone élémentaire et de la zone périphérique d'isolation 106 (cas des zones élémentaires actives 101₁ et 101₄).

La zone de grille (appelé aussi doigt de grille) 104 est agencée entre la zone de source 103 et la zone de drain 102 suivant l'axe Oy perpendiculaire à l'axe Ox selon lequel s'étendent les zones actives élémentaires 101i et les zones élémentaires implantées en oxygène 105j. Selon l'invention, les zones de source, de drain et de grille sont communes à l'ensemble des zones élémentaires actives 101i (i.e. on a une seule zone de source, une seule zone de drain et une seule zone de grille pour la pluralité de zones actives élémentaires101i). En d'autres termes, la zone de grille unique commande l'ensemble des zones actives élémentaires.

Selon ce mode de réalisation, les zones de source 103 et de drain 102 sont à la fois en contact (contact surfacique ou enterré dans les zones) avec les zones actives 101i mais aussi avec les zones élémentaires implantées en oxygène 105j.

Selon l'invention, le doigt de grille 104 est à la fois en contact (contact surfacique ou par l'intermédiaire d'une couche diélectrique, ou enterré dans la couche d'AlGaN) avec les zones actives 101i mais aussi avec les zones élémentaires implantées en oxygène 105j.

Dans la suite de la description, on notera Wa la largeur de chaque zone active 101i mesurée suivant la direction Oy et Wo la largeur de chaque zone élémentaire implantée en oxygène 105j également suivant la direction Oy. On notera également Lg la longueur de grille mesurée selon l'axe Ox. Par convention, la « longueur » (L) correspond à la dimension transversale (Lg,...) et la «largeur » (W) correspond au développement du transistor dans la direction perpendiculaire au plan des coupes transversales.

La figure 4 montre une vue en coupe du composant 100, la coupe étant réalisée selon un plan P1 parallèle au plan Oyz et passant par la zone de grille 104. Le plan des différentes couches est parallèle au plan Oxy de la figure 3.

Le composant 100 comporte un substrat 107. Le substrat 107 est par exemple en silicium (intrinsèque ou dopé), en carbure de silicium (SiC) ou en saphir sur lequel est déposée une couche de transition 108 jouant le rôle de couche de nucléation et d'adaptation des paramètres de mailles entre le substrat 107 et la couche buffer subséquente de GaN 109. La couche de transition 108 permet de gérer les contraintes mécaniques entre le substrat 107 et les couches formées par l'épitaxie. La couche 108 peut inclure la superposition d'une couche de nucléation (typiquement de l'AlN) et plusieurs couches d'adaptation (par exemple plusieurs couches d'AlGaN avec une fraction molaire d'AlN décroissante, ou bien un super-réseau comprenant plusieurs bicouches AlxGa(1-x)N/GaN). Une telle couche intermédiaire 108 s'avère particulièrement avantageuse en cas de forte inadaptation de paramètres de maille entre la couche de GaN déposée au-dessus et le substrat 107, qui pourrait aboutir à un niveau prohibitif de dislocations mécaniques dans ces couches. De manière à ne pas alourdir inutilement les figures, cette couche de transition 108 ne sera pas représentée sur les autres figures.

Le composant 100 comporte ici une couche tampon 109 déposée sur la couche de transition 108. La couche tampon 109 peut présenter une épaisseur dépendant de la tension visée pour le transistor 100. Une épaisseur relativement importante de la couche tampon 109 permet de limiter les courants de fuite latéraux et verticaux dans le transistor 100 et aussi de mieux confiner la couche de gaz d'électrons que nous décrirons par la suite. La couche tampon 109 peut par exemple être réalisée en GaN-SI (semi-isolant) dopé Carbone ou en la superposition d'une couche de GaN-SI/ AlxGa(1-x)N avec x faible, par exemple compris entre 4 à 8%.

Les zones actives 101i sont par exemple formées par un empilement comportant successivement :
- une couche de GaN dopé p 110i disposée sur la couche tampon 109,
- une couche de GaN dopé n 111i disposée sur la couche de GaN dopé p 110i,
- une couche de GaN non intentionnellement dopé (canal) 112i disposée sur la couche de GaN dopé n 111i et,
- une couche d'AlGaN (barrière) 113i disposée sur la couche de GaN non intentionnellement dopé 112i.
On notera qu'il peut y avoir également un « spacer » entre le canal et la barrière, sous la forme d'une couche d'AlN très fine (0.5 à 2nm) qui permet d'améliorer la densité et les propriétés de transport dans le 2DEG.

Pour chaque empilement élémentaire 101i, la couche de GaN non intentionnellement dopé 112i et la couche d'AlGaN 113i forment une hétérojonction de sorte qu'un gaz d'électrons bidimensionnel 114i soit intrinsèquement formé sous l'interface entre la couche de GaN non intentionnellement dopé et la couche d'AlGaN. Les couches d'AlGaN 113i peuvent être recouvertes d'une couche de passivation non représentées sur la figure 4, par exemple en dioxyde de silicium (SiO₂), nitrure de silicium (Si₃N₄), nitrure d'aluminium (AlN), nitrure de galium (GaN) ou alumine (Al₂O₃). Cette couche de passivation sert à bien maîtriser la surface de la couche d'AIGaN.

La couche de GaN dopé p 110i et la couche de GaN dopé n 111i forment ensemble une barrière de potentiel particulièrement élevée (jonction PN déplétée) sous la couche de gaz d'électrons 114i.

Avantageusement, le dopage p de la couche 111i est réalisé avec du Magnésium et le dopage n de la couche 112i est réalisé avec du Silicium.

Une zone implantée en oxygène se trouve de part et d'autre de chaque empilement actif 101i. Il peut s'agir soit d'une partie de la zone périphérique 106 soit d'une zone élémentaire 105j. Ainsi, selon l'invention, deux zones latérales implantées en oxygène sont agencées de part et d'autre de chaque couche de GaN dopé de type p 110i. Dans le mode de réalisation illustré sur les figures 3 et 4, deux zones latérales, 106 ou 105j, implantées en oxygène sont agencées de part et d'autre de l'empilement entier 101i. L'intérêt de ces zones latérales implantées en oxygène sera détaillé par la suite.

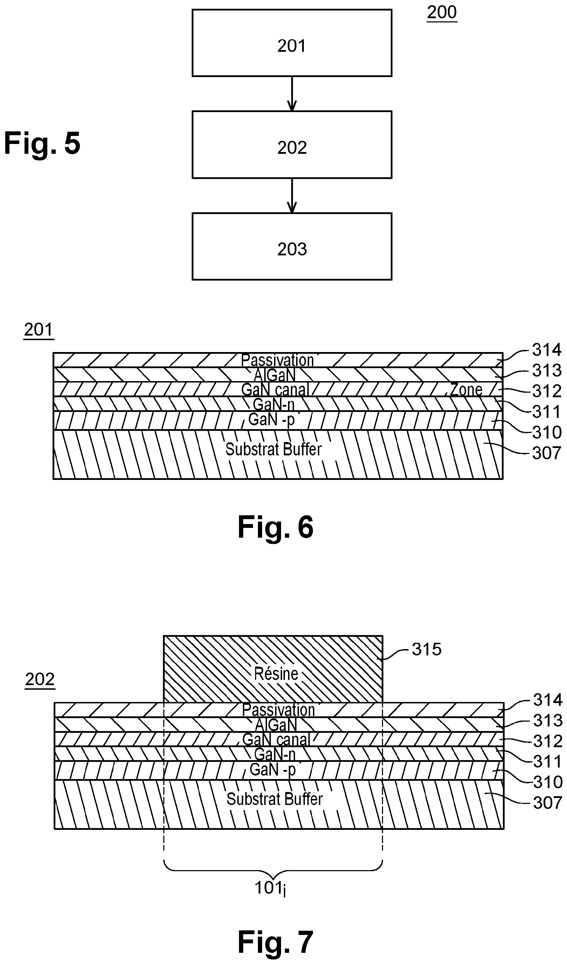

Selon l'invention, la zone active 101 et la zone implantée en oxygène 105 sont réalisées à partir d'un seul et même empilement de couches. Un procédé 200 de réalisation d'un composant comportant la zone active 101 et la zone implantée en oxygène 105 incluant la zone périphérique et la pluralité de zones implantées élémentaires est illustrée aux figures 6 à 8 ainsi que sur la figure 5 représentant les différentes étapes de ce procédé 200.

Le première étape 201 consiste à déposer sur un substrat 307 l'empilement voulu, à savoir dans l'exemple de la figure 6, un empilement incluant :
- une couche de GaN dopé p 310,
- une couche de GaN dopé n 311 disposée sur la couche de GaN dopé p,
- une couche de GaN non intentionnellement dopé 312 disposée sur la couche de GaN dopé n,
- une couche d'AlGaN 313 disposée sur la couche de GaN non intentionnellement dopé,
- une couche de passivation 314.

Cet empilement est obtenu par des techniques d'épitaxie connue de l'homme du métier, par exemple par épitaxie en phase vapeur aux organométalliques MOCVD (Metalorganic Vapor Phase Epitaxy selon la terminologie anglaise). On notera que les couches de transition et tampon ont été volontairement omises sur les figures 6 à 8.

Le procédé 200 comporte ensuite une étape 202 de masquage des zones destinées à former les zones actives élémentaires du composant. Un masque 315 en résine photosensible est ainsi représenté sur la figure 7. Cette étape de masquage est réalisée par des techniques de photolithographie bien connues de l'homme du métier. Le masque 315 sert par exemple ici à délimiter une des zones actives élémentaires 101i.

Le procédé 200 comporte ensuite une étape 203 d'implantation ionique en atomes d'oxygène dans les zones non protégées par la résine, ladite implantation étant destinée à former les zones élémentaires implantées en oxygène et la zone périphérique d'isolation implantée en oxygène. L'étape d'implantation est suivie d'une étape de retrait de la résine, par exemple par décapage ou stripping selon la terminologie anglaise. L'étape de retrait de la résine est suivie d'une étape de recuit thermique à une température d'environ 800°C (entre 700°C et 850°C) pendant 1 à 30 quelques minutes. Le temps nécessaire à la diffusion latérale de l'hydrogène dépend de la température et de la taille W des zones actives.

Le procédé 200 selon l'invention permet ainsi de réaliser l'ensemble de la zone implantée en oxygène 105 représentée sur les figures 3 et 4 incluant la zone périphérique d'isolation 106 et la pluralité de zones implantées en oxygène élémentaires 105j agencées entre chaque zone active élémentaire 101i.

Les zones implantées en oxygènes doivent donc être vues comme des zones ayant subi une implantation en oxygène et un recuit thermique, créant ainsi des poches implantées à la fois autour du composant pour l'isoler mais également au sein du composant pour améliorer l'activation de l'accepteur (ici le Mg) de chaque couche 110i de la barrière de confinement. En effet, on retrouve deux zones latérales 105i qui se retrouvent à la fois de part et d'autre de chaque couche de GaN dopé p 110i mais aussi de part et d'autre du gaz 2DEG 114i. L'implantation d'oxygène conduit à la formation de niveaux profonds (associés aux défauts d'implantation) dans le gap du semiconducteur GaN qui neutralisent complètement le 2DEG à l'endroit de l'implantation. Dans cette zone, le transistor n'est donc pas actif, ce qui assure l'isolation. Le recuit post implantation permet en outre à l'Hydrogène, qui passive le dopant Mg, de diffuser et de réagir avec l'Oxygène implanté. La distance de diffusion de l'Hydrogène étant limitée, il est nécessaire de fractionner les poches d'Oxygène dans la zone active (Figure 3 et 4). Chaque zone élémentaire d'Oxygène 105i de largeur Wo va interagir avec les parties actives 101i de largeur Wa qui lui sont proches.

Avantageusement, la largeur des zones actives élémentaires Wa et des zones élémentaires implantées Oxygène Wo sont au maximum de 20µm pour permettre une interaction efficace entre les atomes d'Oxygène et les atomes d'Hydrogène. Elles sont au minimum de 1µm afin d'éviter la neutralisation complète du 2DEG par la dispersion latérale de l'implantation d'Oxygène dans les zones actives et de respecter les contraintes de masquage de l'étape d'implantation. Dans cette fenêtre comprise entre 1µm et 20µm, le choix de Wo et du taux de zone active Wa/(Wa+Wo) est libre et est dicté par l'objectif de performance du transistor en termes de fréquence, de résistance thermique et de résistances d'accès.

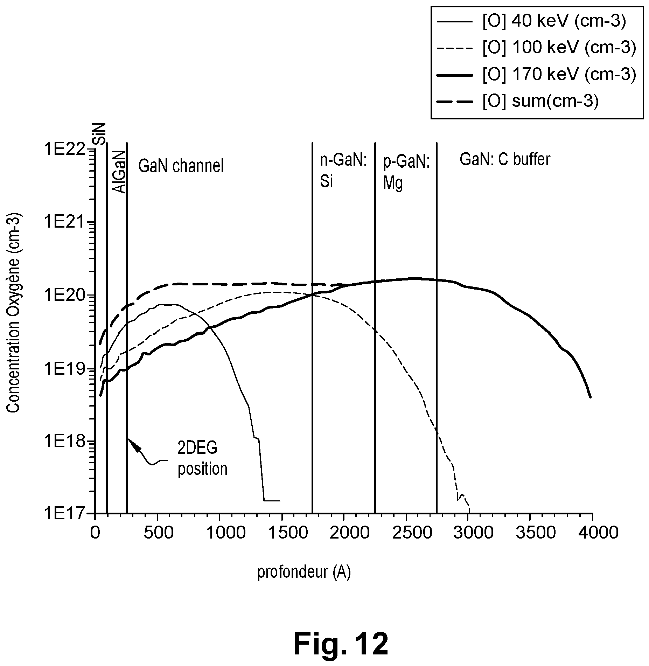

L'étape d'implantation d'oxygène doit être réalisée de sorte que l'oxygène soit présent dans la profondeur de l'empilement et notamment au niveau du gaz 2DEG et de la couche de GaN dopée p. Pour ce faire, on utilisera avantageusement plusieurs énergies d'implantation qui permettent à la fois de neutraliser le 2DEG (isolation) et d'interagir avec la couche dopée Mg enterrée. Il est aussi avantageux d'utiliser une implantation multi-énergies pour répartir la dose d'Oxygène en profondeur. L'épaisseur de la zone implantée en Oxygène est notée t. Elle doit être supérieure ou égale à la profondeur de la couche dopée de GaN dopé p (Mg). Cette dernière étant de l'ordre de 150nm, une énergie maximale de 150-200keV est suffisante et réalisable avec un bâti d'implantation classiquement utilisé dans une salle blanche de type CMOS. Il est connu pour l'homme du métier de choisir une séquence d'énergies et de doses permettant d'obtenir un profil d'Oxygène approximativement plat à la concentration d'oxygène visée. Un exemple d'un tel profil est donné en figure 12. Ce profil d'implantation d'Oxygène est obtenu par implantation triple (40keV avec une dose d'implantation de 5.10¹⁴cm-2, 80keV avec une dose d'implantation de 10¹⁵cm-2 et 170 keV avec une dose d'implantation de 3.10¹⁵cm-2). La concentration d'Oxygène est élevée (i.e. supérieure à 10²⁰cm-3) autour de la couche 110i de p GaN dopé Mg. Les défauts générés par les trois implantations sont suffisants pour neutraliser le gaz 2DEG à l'interface 114i entre la couche 112i d'AlGaN et la couche 113i de GaN non intentionnellement dopée. S'agissant de la dose d'implantation d'Oxygène, Φ_{Oxygène} que l'on peut considérer comme étant approximativement égale à [O] x t, où [O] est la concentration d'oxygène et t est l'épaisseur de la zone implantée en Oxygène, elle est :
- suffisante pour capter l'Hydrogène dans la couche de GaN dopé p ; typiquement, on cherchera à avoir une dose Φ_{Oxygène} > 2.10¹⁴cm⁻² x (Wa/Wo). Cela correspond donc par exemple à une concentration [O]> 1.10¹⁹cm⁻³ si t = 200nm et Wa=Wo ;
- limitée, afin d'éviter les déformations du substrat et de faciliter l'intégration de cette étape aux étapes de fabrication du transistor ; typiquement, on cherchera à avoir une dose Φ_{Oxygène} < 6^{e}15cm-²x (Wa/Wo). Cela correspond à une concentration [O]< 3.10²⁰cm⁻³ si t=200nm et Wa=Wo. Une telle gamme de dose est également suffisante pour isoler le transistor au niveau du gaz 2DEG.

Comme mentionné précédemment, la zone implantée en oxygène n'est pas une zone dopée en oxygène car dans ce cas la majorité de l'oxygène présent serait en site substitutionnel dans le réseau cristallin du GaN et l'oxygène ne serait alors pas disponible pour capter l'hydrogène empêchant l'obtention d'un dopage p dans le GaN par la création de complexes Mg-H. Ainsi, la zone implantée en oxygène doit être vue comme une zone ayant subi une étape d'implantation en atome d'oxygène puis un recuit mais n'ayant pas été soumise à un budget thermique suffisant pour que l'oxygène se comporte en donneur et forme une zone de GaN dopée n. Néanmoins, afin d'éviter de façon encore plus certaine que l'oxygène ne joue pas un rôle de dopant (i.e. donneur) dans le GaN implanté, l'étape 203 d'implantation en oxygène peut être une étape de co-implantation durant laquelle on implante à la fois de l'oxygène et de l'Argon Ar ou de l'azote N. On s'assure de la sorte qu'aucun dopage résiduel de type n n'apparaisse et ne dégrade la forte résistivité de la zone implantée.

En plus du rôle d'activateur du dopage p dans la couche de GaN de la barrière de confinement et d'isolant du gaz 2DEG du transistor, l'utilisation des zones latérales 105j implantées en oxygène permet de fractionner (cf. vue de dessus en figure 3) les zones actives 101i de puissance. Les zones actives d'un transistor de puissance sont en effet des sources de chaleurs localisées dont l'extension vaut Wg x L, où Wg est le développement de la grille et L est la longueur de la source de chaleur (qui peut être plus grande que Lg) mesurée suivant l'axe Ox, L étant par exemple égale à 0.5µm. Wg correspond à la largeur de grille, mesurée suivant l'axe Oy en vis-à-vis de la zone active. En Fractionnant la zone active du transistor en sources de chaleur unitaires Wa, espacées de Wo, on limite le couplage thermique entre ces sources. La résistance thermique du transistor s'en trouve réduite.

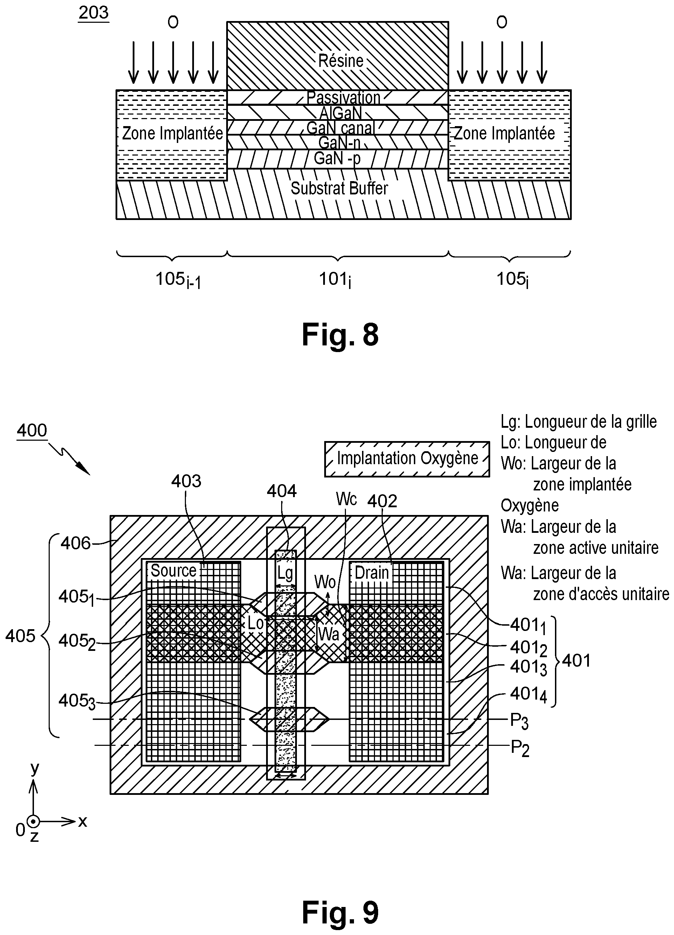

La figure 9 représente une variante du transistor selon l'invention représenté en figure 3. Comme dans le cas de la figure 3, la figure 9 représente une vue de dessus d'un transistor HEMT 400 selon l'invention dans un plan Oxy. Comme le transistor 100, le transistor 400 comporte :
- Une zone active 401 incluant une pluralité de zones actives élémentaires 401i ;
- Une zone de drain 402 ;
- Une zone de source 403 ;
- Une zone de grille 404 ;
- Une zone implantée en oxygène 405 incluant :
   - une zone périphérique d'isolation 406 ;
   - une pluralité de zones élémentaires implantées en oxygène 405ⱼ agencées entre chaque zone active élémentaire 401i.

Les zones actives, de drain, de source et de grille ainsi que la zone périphérique d'isolation sont identiques aux zones correspondantes de la figure 3.

En revanche, cette variante de l'invention consiste à implanter l'oxygène seulement dans la zone de grille mais pas jusqu'aux zones de source et de drain. En d'autres termes, les zones implantées en oxygène élémentaires 405ⱼ sont agencées pour être sous la zone de grille mais pour ne pas être présentes au niveau des zones de drain et de source. Le procédé de fabrication des zones implantées en oxygène est identique à celui de la figure 5, la différence résidant dans la forme du motif de résine destiné à couvrir les zones non implantées. Selon la variante de la figure 9, la largeur Wc des zones d'accès élémentaires de source et de drain est plus grande que dans le cas du transistor de la figure 3 où la largeur des zones d'accès de source et de drain étaient égales à la largeur de la zone active Wa. En outre, les résistances d'accès (source et drain) sont plus faibles du fait de l'absence des zones implantées fortement résistives du côté du drain et de la source. Un tel mode de réalisation augmente donc la performance du transistor. La forme de la zone implantée Oxygène doit être suffisamment large autour de la grille (Wo) et se réduire progressivement vers les accès de source et de drain. Bien entendu, la surface de chaque zone élémentaire implantée en oxygène doit être suffisamment grande pour assurer une quantité d'oxygène suffisante et permettre l'activation des dopants de type p de la couche de GaN au niveau de la grille : en effet, la barrière de confinement doit être surtout efficace au niveau de la grille (d'où l'importance d'observer le phénomène de neutralisation de l'hydrogène à proximité de la grille, à l'endroit où les électrons du 2DEG ont un maximum d'énergie).

De façon connue, les zones de source et de drain sont soit en contact direct avec la couche d'AlGaN soit enterrées (« recess » selon la terminologie anglaise) dans la couche d'AlGaN et partiellement dans la couche de GaN non intentionnellement dopé. De même, la zone de grille peut être une grille de type Schottky (jonction métal semiconducteur), une grille légèrement enterrée dans l'empilement des couches semiconductrices ou une grille de type MIS (Métal Isolant Semiconducteur). Ainsi, les zones latérales élémentaires implantées en oxygène peuvent être sous la zone de grille (cas d'un contact Schottky ou MIS) ou être directement en contact avec la zone de grille (cas d'une grille enterrée dans les zones latérales élémentaires implantées en oxygène). De même, selon le mode de réalisation de la figure 3, les zones latérales élémentaires implantées en oxygène peuvent être sous les zones de source et de drain (cas d'un contact direct avec la couche d'AlGaN) ou être directement en contact avec les zones de source et de drain (cas d'une zone de drain ou de source enterrée dans la couche d'AlGaN et partiellement dans la couche de GaN non intentionnellement dopé).

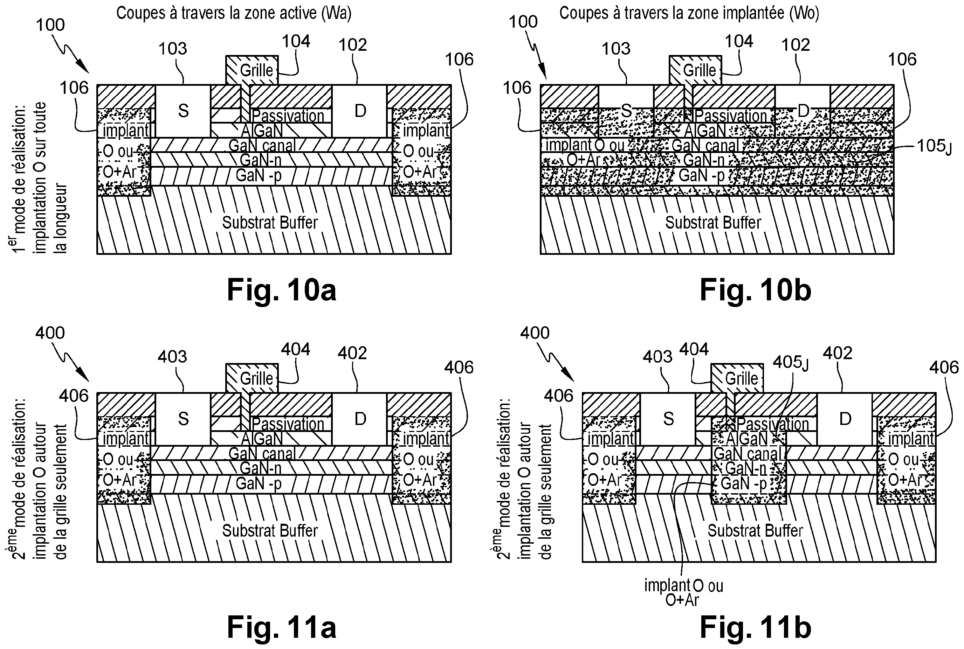

La présence des zones implantées en oxygène selon que le composant selon l'invention est celui de la figure 3 ou celui de la figure 9 est respectivement illustrée par aux figures 10a et 10b (mode de réalisation de la figure 3) et par les figures 11a et 11b (mode de réalisation de la figure 9).

En référence à la figure 3, la figure 10a montre une coupe du dispositif 100 selon un plan P2 parallèle au plan Oxz et passant par une zone active 101i. La figure 10b montre une coupe du dispositif 100 selon un plan P3 parallèle au plan Oxz et passant par une zone élémentaire implantée en oxygène 105j. On notera que les zones de source et de drain 103 et 102 sont ici enterrées tandis que la zone de grille est en contact avec la couche d'AlGaN. On constate ici que les zones élémentaires implantées en oxygène 105j (cf. figure 10b) sont au niveau de la zone de grille 104 et qu'elles s'étendent au niveau des zones de source 103 et de drain 102. Les figures 10a et 10b montrent la zone périphérique 106 implantée en oxygène isolant le composant sur son contour.

En référence à la figure 9, la figure 11a montre une coupe du dispositif 400 selon un plan P2 parallèle au plan Oxz et passant par une zone active 401i. La figure 10b montre une coupe du dispositif 400 selon un plan P3 parallèle au plan Oxz et passant par une zone élémentaire implantée en oxygène 405j. On constate ici que les zones élémentaires implantées en oxygène 405j (cf. figure 11b) sont uniquement au niveau de la zone de grille 404 et qu'elles ne s'étendent pas au niveau des zones de source 403 et de drain 402. Les figures 11a et 11b montrent la zone périphérique 406 implantée en oxygène isolant le composant sur son contour.

Bien entendu l'invention ne se limite pas aux modes de réalisation qui viennent d'être décrits. Ainsi, même si les modes de réalisation décrits concernent des transistors HEMT, l'invention s'applique également à d'autres composants électroniques, notamment optoélectroniques, dès lors que ces derniers comportent au moins une couche en GaN dopé p recouverte d'une autre couche semiconductrice empêchant l'exo-diffusion de l'hydrogène.

## Revendications

1. Composant électronique (100, 400) comprenant :
- Un substrat (107)
- Une pluralité d'empilements actifs (101i), chaque empilement actif (101i) étant formé au-dessus du substrat et incluant :
∘ une couche (110i) en Nitrure de Galium GaN dopé de type p, disposée au-dessus du substrat (107) ;
∘ une couche (111i) en un matériau semi-conducteur disposée sur la couche (110i) en Nitrure de Galium GaN dopé de type p ;
**caractérisé en ce que** le composant comporte deux zones latérales (105i) situées de part et d'autre de la couche (110i) de GaN dopé de type p respective de chaque empilement actif (101i), les deux zones latérales étant implantées en oxygène.

2. Composant électronique (100, 400) selon la revendication précédente **caractérisé en ce que** les accepteurs de la couche en Nitrure de Galium GaN dopé de type p sont des atomes de Magnésium.

3. Composant électronique (100, 400) selon la revendication précédente **caractérisé en ce que** la largeur (Wa) de chaque empilement actif et la largeur (Wo) de chacune des zones implantées en oxygène sont inférieures ou égales à 20µm et supérieures ou égales à 1µm, la largeur étant mesurée parallèlement au plan des couches dans l'alignement de chaque empilement actif et des zones implantées en oxygène.

4. Composant électronique (100, 400) selon l'une des revendications précédentes **caractérisé en ce que** chaque empilement actif (101i) comporte :
- une couche de GaN dopé de type n (111i) disposée sur la couche de GaN dopé de type p ;
- une couche de GaN non intentionnellement dopée (112i) disposée sur la couche de GaN dopé de type n ;
- une couche semi-conductrice (113i) disposée sur la couche de GaN non intentionnellement dopée pour former un gaz d'électrons bidimensionnel ;
le composant comportant en outre une zone de source(103), une zone de drain (102) et une zone de grille (104) de commande formées sur ou dans la couche semi-conductrice pour former un gaz d'électrons bidimensionnel ;
les deux zones latérales implantées en oxygène s'étendant également de part et d'autre de la couche de GaN dopé de type n, de la couche de GaN non intentionnellement dopée et de la couche semi-conductrice pour former un gaz d'électrons bidimensionnel.

5. Composant électronique selon la revendication 4 **caractérisé en ce que**
- chaque empilement actif comporte :
∘ une couche de GaN dopé de type n disposée sur la couche de GaN dopé de type p ;
∘ une couche de GaN non intentionnellement dopée disposée sur la couche de GaN dopé de type n ;
∘ une couche semi-conductrice disposée sur la couche de GaN non intentionnellement dopée pour former un gaz d'électrons bidimensionnel ;
∘ deux zones latérales implantées en oxygène s'étendant de part et d'autre de la couche de GaN dopé de type p, de la couche de GaN dopé de type n, de la couche de GaN non intentionnellement dopée et de la couche semi-conductrice pour former un gaz d'électrons bidimensionnel
- les zones de source, de drain et de grille de commande étant
communes à la pluralité d'empilements actifs ;
chaque empilement actif étant isolé électriquement de l'empilement actif adjacent par une des zones latérales implantées en oxygène.

6. Composant électronique selon la revendication précédente **caractérisé en ce que** la pluralité desdits empilements est entouré d'une zone, dite d'isolation, ladite zone d'isolation étant une zone implantée en oxygène.

7. Composant électronique selon l'une des revendications 4 à 6 **caractérisé en ce que** chacune des deux zones latérales implantées en oxygène s'étend dans ou sous la zone de grille et dans ou sous la zone de drain et la zone de source.

8. Composant électronique selon l'une des revendications 4 à 6 **caractérisé en ce que** chacune des deux zones latérales implantées en oxygène s'étend dans ou sous la zone de grille et ne s'étend pas dans ou sous la zone de drain et la zone de source.

9. Procédé (200) de fabrication d'un composant selon l'une des revendications précédentes **caractérisé en ce qu'**il comporte les étapes suivantes :
- Réalisation (201) sur un substrat (307) d'une pluralité d'empilements actifs formée au-dessus du substrat, chaque empilement actif incluant :
∘ une couche (310) en Nitrure de Galium GaN dopé de type p, disposée au-dessus du substrat (307) ;
∘ une couche (311) en un matériau semi-conducteur disposée sur la couche en Nitrure de Galium GaN dopé de type p ;
- Réalisation (202) d'un masque (315) au-dessus de la pluralité d'empilements, ledit masque masquant chaque empilement actif ;
- Implantation ionique (203) pour introduire des atomes d'oxygène dans les deux zones de chaque empilement actif situées de part et d'autre de la zone masquée de sorte à obtenir deux zones latérales dans la couche en Nitrure de Galium GaN dopé de type p implantées en oxygène ;
- Recuit (202) suivant l'implantation ionique.

10. Procédé selon la revendication précédente **caractérisé en ce que** la température de recuit est comprise entre 700 et 850°C.

11. Procédé selon l'une des revendications 9 ou 10 **caractérisé en ce que** l'implantation est une implantation multi-énergies.

12. Procédé selon l'une des revendications 9 à 11 **caractérisé en ce que** l'énergie des atomes d'oxygènes ionisés utilisée pour l'implantation est inférieure ou égale à 200 keV.

13. Procédé selon l'une des revendications 9 à 12 **caractérisé en ce que** la dose d'atomes d'oxygène implantés est :
- supérieure à 2.10¹⁴cm⁻² x (Wa/Wo) où Wa désigne la largeur de l'empilement actif et Wo désigne la largeur des zones latérales implantées et ;
- inférieure à 6.10¹⁵cm⁻² x (Wa/Wo),
la largeur étant mesurée parallèlement au plan des couches dans l'alignement de chaque empilement actif et des zones implantées en oxygène.

14. Procédé selon l'une des revendications 9 à 13 **caractérisé en ce que** l'étape d'implantation ionique pour introduire des atomes d'oxygène s'accompagne d'une étape d'implantation ionique pour introduire des atomes d'argon ou d'azote.
